# EUROPÄISCHE PATENTANMELDUNG

(11) **EP 2 755 247 A1**
(43) Veröffentlichungstag der Anmeldung: **16.07.2014**
(21) Anmeldenummer: 13192313.8
(22) Anmeldetag: 11.11.2013
(51) Int. Cl.: H01L 41/047, H01L 41/083, H01L 41/09, H01L 41/113, H01L 41/293

(54) **Piezoelektrisches Bauteil und Verfahren zur Herstellung eines piezoelektrischen Bauteils**

(30) Priorität: 10.01.2013 DE 102013200244
(71) Anmelder: ROBERT BOSCH GMBH, 70442 Stuttgart (DE)
(72) Erfinder: Melcher, Reinhold, 91052 Erlangen (DE)

(57) **Zusammenfassung**

Ein piezoelektrisches Bauteil (1), das insbesondere als piezoelektrischer Sensor oder piezoelektrischer Aktor dient, umfasst einen Grundkörper (6), der eine erste keramische Schicht (7), eine zweite keramische Schicht (8) und eine innen liegende Elektrodenschicht (9) aufweist. Dabei ist die innen liegende Elektrodenschicht (9) zumindest teilweise zwischen der ersten keramischen Schicht (7) und der zweiten keramischen Schicht (8) vorgesehen. Der Grundkörper (6) weist eine Bohrung (10) auf, die zumindest teilweise im Bereich der innen liegenden Elektrodenschichten (9) vorgesehen ist. Ferner ist in die Bohrung (10) des Grundkörpers (6) zumindest teilweise ein elektrisches Kontaktelement (13) eingefügt, das in der Bohrung (10) zumindest mittelbar mit der innen liegenden Elektrodenschicht (9) elektrisch verbunden ist. Ferner ist ein Verfahren zur Herstellung solch eines piezoelektrischen Bauteils (1) angegeben.

## Beschreibung

### Stand der Technik

Die Erfindung betrifft ein piezoelektrisches Bauteil, insbesondere einen piezoelektrischen Sensor oder einen piezoelektrischen Aktor, sowie ein Verfahren zur Herstellung solch eines piezoelektrischen Bauteils. Speziell betrifft die Erfindung das Gebiet der piezoelektrischen Bauteile für Brennstoffeinspritzanlagen.

Aus der DE 10 2010 00 827 A1 ist ein Kraftstoffinjektor mit einem Kraft- oder Drucksensor bekannt. Bei dem bekannten Kraftstoffinjektor ist der Kraft- oder Drucksensor einem Steuerraum zugeordnet, dessen Druck die Hübe beziehungsweise Stellungen einer Düsennadel bestimmt. Über den Kraft- oder Drucksensor kann hierbei der Verlauf eines Steuerraumdruckes erfasst werden.

Bei der Ausgestaltung eines piezoelektrischen Bauteils, insbesondere eines piezoelektrischen Drucksensors, ist es denkbar, dass innen liegende Elektrodenschichten über geeignete Außenelektroden kontaktiert werden. Solch eine elektrische Kontaktierung erfordert aber mehrere Materialien und Komponenten sowie Prozessschritte bei der Herstellung. Somit ist diese Art der elektrischen Kontaktierung entsprechend aufwändig und teuer. Beispielsweise kann bei einem piezoelektrischen Aktor auf den geschliffenen Aktor zunächst eine Grundmetallisierung aufgebracht werden, welche anschließend eingebrannt wird. Auf diese Grundmetallisierung kann ein siebartiges Gewebe aufgelötet werden, an welches wiederum das eigentliche Anschlusskabel angeschweißt werden kann.

### Offenbarung der Erfindung

Das erfindungsgemäße piezoelektrische Bauteil mit den Merkmalen des Anspruchs 1 und das erfindungsgemäße Verfahren mit den Merkmalen des Anspruchs 7 haben den Vorteil, dass eine verbesserte Ausgestaltung des piezoelektrischen Bauteils und/oder eine kostengünstigere Herstellung ermöglicht sind. Insbesondere können eine oder mehrere aufwändige Außenelektrodenanbindungen eingespart werden.

Durch die in den Unteransprüchen aufgeführten Maßnahmen sind vorteilhafte Weiterbildungen des im Anspruch 1 angegebenen piezoelektrischen Bauteils und des im Anspruch 7 angegebenen Verfahrens möglich.

Vorteilhaft ist es, dass das elektrische Kontaktelement durch Klemmen in der Bohrung des Grundkörpers befestigt ist. Hierbei kann die Bohrung in den Grünling für den Grundkörper eingebracht werden. Somit wird die Bohrung noch vor dem Sintern ausgestaltet. Dann kann das elektrische Kontaktelement zumindest teilweise in die Bohrung des Grünlings eingebracht werden. Das elektrische Kontaktelement kann hierbei direkt in die Bohrung des Grünlings eingebracht werden. Das bedeutet, dass das elektrische Kontaktelement ohne eine Metallisierungspaste oder dergleichen in die Bohrung des Grünlings eingebracht ist. Anschließend kann der Grünling mit dem in die Bohrung eingebrachten elektrischen Kontaktelement gesintert werden, wobei das elektrische Kontaktelement aufgrund einer Sinterschwindung des Grünlings direkt in der Bohrung des Grundkörpers befestigt wird. Die Befestigung erfolgt hierbei durch Klemmen. Somit ist sowohl eine mechanische Verbindung mit dem Grundkörper als auch eine elektrische Verbindung mit der innen liegenden Elektrodenschicht ausgebildet.

Vorteilhaft ist es auch, dass das elektrische Kontaktelement mittels eines Hilfsstoffes in der Bohrung des Grundkörpers befestigt ist. Insbesondere ist es vorteilhaft, dass der Hilfsstoff als elektrisch leitender Hilfsstoff ausgebildet ist und dass das elektrische Kontaktelement mittels des elektrisch leitenden Hilfsstoffs mit der innen liegenden Elektrodenschicht elektrisch verbunden ist. Hierbei kann eine Paste, insbesondere eine Metallisierungspaste, vor dem Sintern in die Bohrung des Grünlings eingebracht werden. Somit ist das elektrische Kontaktelement dann mit der Paste in die Bohrung des Grünlings eingebracht. Nach dem Sintern bildet die Paste den Hilfsstoff aus. Das elektrische Kontaktelement ist dann mittels des Hilfsstoffs in der Bohrung des Grundkörpers befestigt und vorzugsweise über den elektrisch leitend ausgestalteten Hilfsstoff mit der Elektrodenschicht elektrisch verbunden.

Möglich ist es allerdings auch, dass der Grünling, in den die Bohrung eingebracht ist, zunächst gesintert wird und dass anschließend das elektrische Kontaktelement mittels eines Hilfsstoffs zumindest teilweise in die Bohrung des Grundkörpers eingefügt wird, wobei das elektrische Kontaktelement in der Bohrung durch den Hilfsstoff mit dem Grundkörper verbunden ist. Hierbei ist der Hilfsstoff vorzugsweise als elektrisch leitender Hilfsstoff ausgestaltet. Somit ist über den elektrisch leitenden Hilfsstoff sowohl eine mechanische Verbindung mit dem Grundkörper als auch eine elektrische Verbindung mit der Elektrodenschicht gewährleistet.

Möglich ist es allerdings auch, dass der Grünling für den Grundkörper zunächst gesintert wird und dass die Bohrung erst nach dem Sintern in dem Grundkörper ausgestaltet wird. Das elektrische Kontaktelement kann dann ebenfalls durch einen Hilfsstoff in der Bohrung des Grundkörpers befestigt werden. Hierbei ist über einen elektrisch leitenden Hilfsstoff zugleich eine elektrische Verbindung mit der Elektrodenschicht gewährleistet.

Bei einer möglichen Ausgestaltung ist eine Achse der Bohrung, in der das elektrisch leitende Kontaktelement befestigt wird, zumindest näherungsweise parallel zu der innen liegenden Elektrodenschicht orientiert. Speziell bei einer Ausgestaltung des Grundkörpers als plattenförmiger oder scheibenförmiger Grundkörper kann hierbei in vorteilhafter Weise eine seitliche Kontaktierung realisiert werden. Diese Ausgestaltung eignet sich besonders für den Fall, dass der Grundkörper genau eine innen liegende Elektrodenschicht aufweist. Weitere Elektrodenschichten können hierbei an den Stirnseiten des Grundkörpers durch Metallisierungen ausgebildet werden.

Bei einer weiteren möglichen Ausgestaltung ist es vorteilhaft, dass zumindest eine weitere innen liegende Elektrodenschicht vorgesehen ist, dass die Bohrung zumindest teilweise im Bereich der innen liegenden Elektrodenschicht und zumindest teilweise im Bereich der weiteren innen liegenden Elektrodenschicht vorgesehen ist und dass eine Achse der Bohrung zumindest näherungsweise senkrecht zu der innen liegenden Elektrodenschicht und der weiteren innen liegenden Elektrodenschicht orientiert ist. Auf diese Weise ist eine elektrische Kontaktierung mehrerer Elektrodenschichten möglich. Hierbei können auch mehrere Bohrungen, insbesondere zwei Bohrungen, vorgesehen sein, um eine Vielzahl von Elektrodenschichten abwechselnd zu kontaktieren.

### Kurze Beschreibung der Zeichnungen

Bevorzugte Ausführungsbeispiele der Erfindung sind in der nachfolgenden Beschreibung unter Bezugnahme auf die beigefügten Zeichnungen, in denen sich entsprechende Elemente mit übereinstimmenden Bezugszeichen versehen sind, näher erläutert. Es zeigen:
Fig. 1 ein Prozessflussdiagramm zur Erläuterung eines Verfahrens zur Herstellung eines piezoelektrischen Bauteils entsprechend einem ersten Ausführungsbeispiel der Erfindung;
Fig. 2 ein piezoelektrisches Bauteil entsprechend einem zweiten Ausführungsbeispiel der Erfindung in einer schematischen Schnittdarstellung;
Fig. 3 ein Prozessflussdiagramm zur Erläuterung von Verfahren zur Herstellung eines piezoelektrischen Bauteils entsprechend möglicher Ausgestaltungen der Erfindung und
Fig. 4 ein piezoelektrisches Bauteil entsprechend einem dritten Ausführungsbeispiel der Erfindung in einer schematischen Schnittdarstellung.

### Ausführungsformen der Erfindung

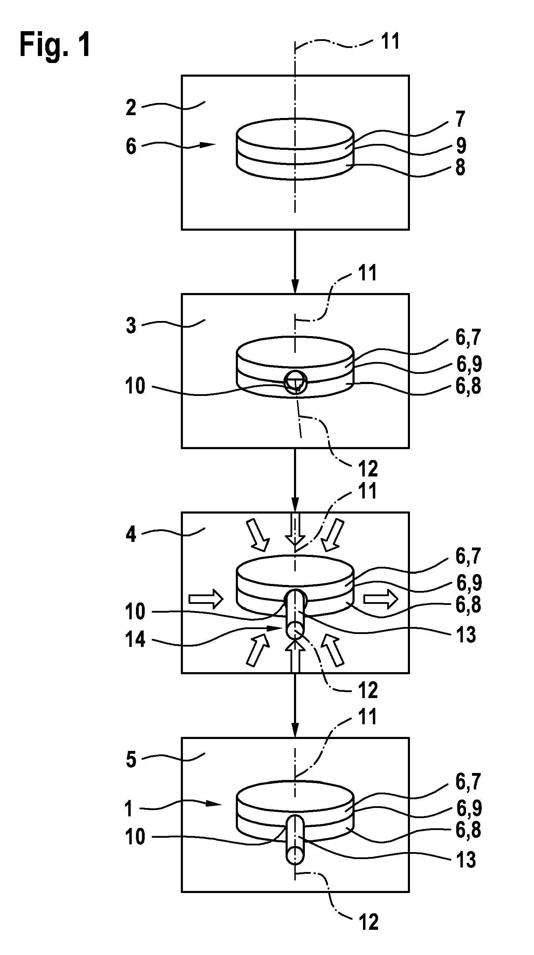

Fig. 1 zeigt ein Prozessflussdiagramm zur Erläuterung eines Verfahrens zur Herstellung eines piezoelektrischen Bauteils 1 entsprechend einem ersten Ausführungsbeispiel. Das piezoelektrische Bauteil 1 kann insbesondere als piezoelektrischer Sensor 1 oder piezoelektrischer Aktor 1 ausgestaltet sein. Speziell kann das piezoelektrische Bauteil 1 bei Brennstoffeinspritzanlagen zum Einsatz kommen. Beispielsweise kann ein piezoelektrischer Sensor 1 als Nadelschließsensor dienen, der ein Schließen einer Ventilnadel eines Brennstoffeinspritzventils überwacht. Hierbei kann der Sensor 1 auch einen Druckverlauf innerhalb eines Brennstoffraums des Brennstoffeinspritzventils messen. Solch ein Sensor 1 kann auch als Brennraumdrucksensor ausgestaltet sein, der direkt oder indirekt den Druck in einem Brennraum einer Brennkraftmaschine misst. Der piezoelektrische Sensor 1 eignet sich allerdings auch für andere Anwendungsfälle, insbesondere im Kraftfahrzeugbereich. Speziell kann der Sensor 1 auch als Betriebsmittelsensor für Hydraulik- oder Pneumatikanwendungen zum Einsatz kommen.

In dem in der Fig. 1 dargestellten Prozessflussdiagramm sind Verfahrensschritte 2, 3, 4, 5 veranschaulicht. Im Verfahrensschritt 2 wird ein Grünling 6 hergestellt, der aus einer ersten keramischen Schicht 7, einer zweiten keramischen Schicht 8 und einer innen liegenden Elektrodenschicht 9 aufgebaut wird. Aus dem Grünling 6 wird ein Grundkörper 6 des piezoelektrischen Bauteils 1. Der Grundkörper 6 befindet sich allerdings im Verfahrensschritt 2 noch in einem Grünzustand.

Im Verfahrensschritt 3, der auf den Verfahrensschritt 2 folgt, wird in dem Grünling 6 beziehungsweise dem Grundkörper 6 eine Bohrung 10 ausgestaltet. Die Bohrung 10 ist hierbei im Bereich der innen liegenden Elektrodenschicht 9 vorgesehen.

Der Grundkörper 6 weist eine Achse 11 auf. Entlang der Achse 11 erfolgt im Betrieb gegebenenfalls eine Beaufschlagung des piezoelektrischen Bauteils 1, um eine Messspannung oder dergleichen zu erzeugen. Gegebenenfalls kann entlang der Achse 11 auch eine Dehnung des piezoelektrischen Bauteils 1 genutzt werden, um eine Verstellkraft zu erzeugen, wenn das piezoelektrische Bauteil 1 als Aktor 1 ausgestaltet ist.

Eine Achse 12 der Bohrung 10 ist in diesem Ausführungsbeispiel senkrecht zu der Achse 11 orientiert. Dadurch ist die Achse 12 der Bohrung 10 parallel zu der innen liegenden Elektrodenschicht 9 orientiert.

Im Verfahrensschritt 4, der auf den Verfahrensschritt 3 folgt, wird eine elektrisches Kontaktelement 13 teilweise in die Bohrung 10 eingefügt. Ein freiliegender Abschnitt 14 des elektrischen Kontaktelements 13 verbleibt hierbei außerhalb der Bohrung 10 des Grünlings 6. Anschließend wird der Grünling 6 entbindert und gesintert. Durch die Sinterung schwindet der Grünling 6. Das elektrische Kontaktelement 13 wird dadurch in der Bohrung 10 geklemmt. Somit wird das elektrische Kontaktelement 13 mechanisch in der Bohrung 10 des Grundkörpers 6 befestigt. Außerdem wird hierdurch eine elektrische Verbindung zwischen dem elektrischen Kontaktelement 13 und der innen liegenden Elektrodenschicht 9 ausgebildet. Die elektrische Verbindung besteht in diesem Ausführungsbeispiel direkt zwischen dem elektrischen Kontaktelement 13 und der innen liegenden Elektrodenschicht 9.

Im Verfahrensschritt 5, der auf den Verfahrensschritt 4 folgt, ist das piezoelektrische Bauteil 1 nach dem Sintern dargestellt. Hierbei ist der zum Einfügen des Kontaktelements 13 in die Bohrung 10 verbleibende Raum aufgrund der Schrumpfung verschwunden. Das Material des Grünlings 6 hat sich hierbei an die Kontur des elektrischen Kontaktelements 13 angepasst.

Das elektrische Kontaktelement 13 kann durch einen Stift, einen Draht oder dergleichen gebildet sein. Als Werkstoffe für das elektrische Kontaktelement 13 kommen beispielsweise Nickel, Kupfer, Silber, Palladium, Gold oder Platin zum Einsatz. Auch eine geeignete Legierung mit einem oder mehreren dieser Werkstoffe ist vorteilhaft.

Bei der Herstellung des piezoelektrischen Bauteils ist es vorteilhaft, dass das elektrische Kontaktelement 13 bereits sehr früh während der Herstellung in den Grünling 6 eingebracht werden kann, wie es anhand des Verfahrensschritts 4 beschrieben ist. Dadurch kann das elektrische Kontaktelement 13 bereits vor einem Entbindern und einem Sintern des piezokeramischen Werkstoffs für die keramischen Schichten 7, 8 eingebracht werden. Hierdurch ist eine sichere Kontaktierung der innen liegenden Elektrodenschicht 9 auch ohne einen Hilfsstoff möglich. Zur Ausgestaltung der mechanischen und elektrischen Verbindung wird hierbei die Sinterschwindung des Grünlings 6 genutzt.

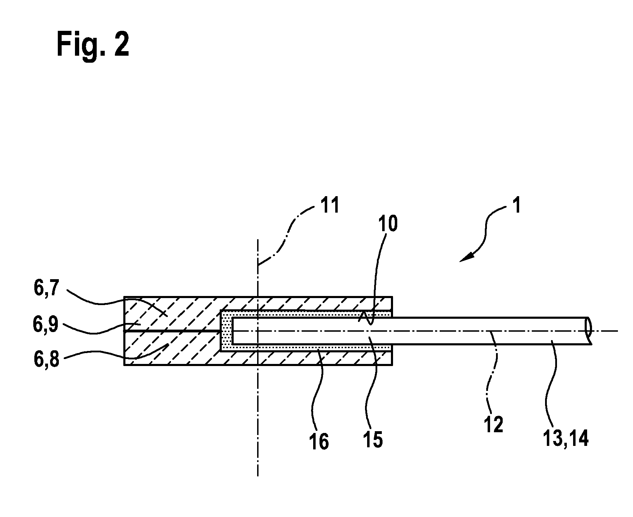

Fig. 2 zeigt ein piezoelektrisches Bauteil 1 entsprechend einem zweiten Ausführungsbeispiel in einer schematischen Schnittdarstellung. Das elektrische Kontaktelement 13 ist teilweise in die Bohrung 10 eingefügt. Hierbei befindet sich ein Verbindungsabschnitt 15 des elektrischen Kontaktelements 13 in der Bohrung 10 des Grundkörpers 6. Der freiliegende Abschnitt 14 des elektrischen Kontaktelements 13 befindet sich außerhalb der Bohrung 10. Der Verbindungsabschnitt 15 des Kontaktelements 13 ist hierbei senkrecht zu der Achse 11 orientiert. Somit ist der Verbindungsabschnitt 15 parallel zu der innen liegenden Elektrodenschicht 9 orientiert.

In diesem Ausführungsbeispiel ist das elektrische Kontaktelement 13 mittels eines Hilfsstoffes 16 in der Bohrung 10 des Grundkörpers 6 befestigt. Der Hilfsstoff 16 ist hierbei als elektrisch leitender Hilfsstoff 16 ausgebildet. Der Hilfsstoff 16 kann beispielsweise aus einer Metallisierungspaste gebildet sein, die vor einem Entbindern und Sintern in die Bohrung 10 eingebracht wird. Der Hilfsstoff 16 kann allerdings bei einer abgewandelten Ausgestaltung auch nach dem Entbindern und Sintern des Grünlings 6 in die Bohrung 10 eingebracht werden.

Durch den elektrisch leitenden Hilfsstoff 16 ist außerdem eine elektrische Verbindung zwischen dem elektrischen Kontaktelement 13 und der innen liegenden Elektrodenschicht 9 gebildet. Somit ist das elektrische Kontaktelement 13 in der Bohrung in diesem Ausführungsbeispiel mittelbar mit der innen liegenden Elektrodenschicht 9 verbunden.

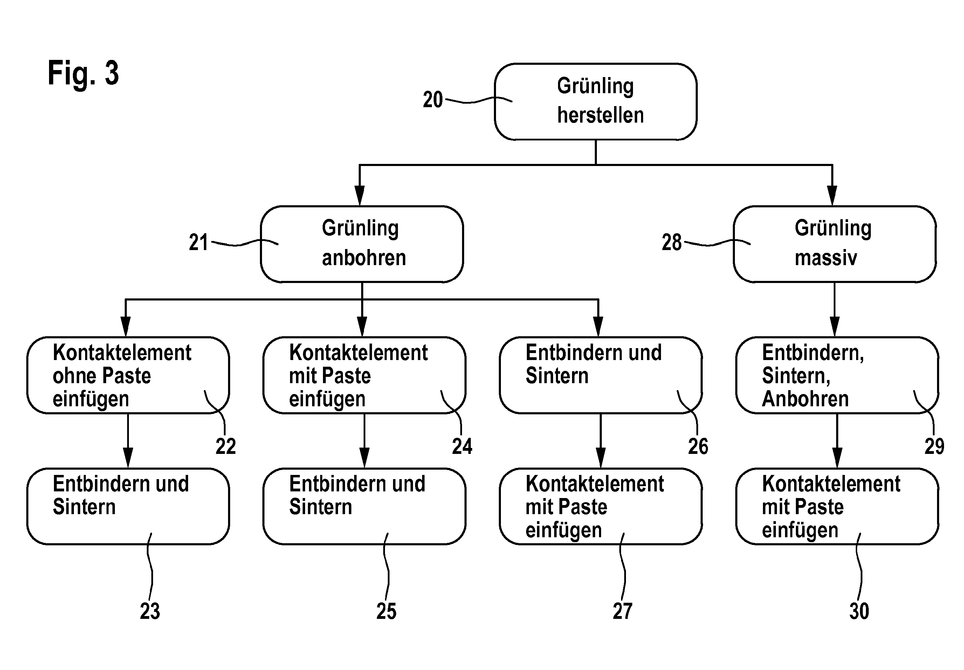

Fig. 3 zeigt ein Prozessflussdiagramm zur Erläuterung von Verfahren zur Herstellung eines piezoelektrischen Bauteils 1 entsprechend möglicher Ausgestaltungen. Hierbei sind die Verfahrensschritte 20 bis 30 dargestellt, die entsprechend der jeweils gewählten Ausgestaltung entlang der dargestellten Pfeile durchlaufen werden. Hierbei sind die folgenden Schlagworte zugeordnet.
Verfahrensschritt 20: "Grünling herstellen";
Verfahrensschritt 21: "Grünling anbohren";
Verfahrensschritt 22: "Kontaktelement ohne Paste einfügen";
Verfahrensschritt 23: "Entbindern und Sintern";
Verfahrensschritt 24: "Kontaktelement mit Paste einfügen";
Verfahrensschritt 25: "Entbindern und Sintern";
Verfahrensschritt 26: "Entbindern und Sintern";
Verfahrensschritt 27: "Kontaktelement mit Paste einfügen";
Verfahrensschritt 28: "Grünling massiv";
Verfahrensschritt 29: "Entbindern, Sintern, Anbohren" und
Verfahrensschritt 30: "Kontaktelement mit Paste einfügen".

Im Verfahrensschritt 20 wird der Grünling 6 hergestellt, wobei dieser aus mehreren keramischen Schichten 7, 8 und zumindest einer innen liegenden Elektrodenschicht 9 ausgestaltet werden kann. Nach dem Verfahrensschritt 20 kann entweder der Verfahrensschritt 21 oder der Verfahrensschritt 28 gewählt werden.

Im Verfahrensschritt 21 wird der Grünling 6 angebohrt. Dadurch wird die Bohrung 10 ausgestaltet. Auf den Verfahrensschritt 21 folgt einer der Verfahrensschritte 22, 24, 26.

Im Verfahrensschritt 22 wird das elektrische Kontaktelement 13 ohne eine Paste direkt in die Bohrung 10 des Grünlings 6 eingefügt. In dem Verfahrensschritt 23, der auf den Verfahrensschritt 22 folgt, wird der Grünling 6 zusammen mit dem in die Bohrung 10 eingefügten elektrischen Kontaktelement 13 entbindert und gesintert. Hierdurch wird das piezoelektrische Bauteil 1 hergestellt.

Bei einer weiteren möglichen Ausgestaltung folgt auf den Verfahrensschritt 21 der Verfahrensschritt 24. Im Verfahrensschritt 24 wird das elektrische Kontaktelement 13 mit einer Paste 16, aus der der Hilfsstoff 16 gebildet wird, in die Bohrung 10 des Grünlings 6 eingefügt. Anschließend wird der Grünling 6 mit dem in die Bohrung 10 eingefügten Hilfsstoff 16 und dem elektrischen Kontaktelement 13 im Verfahrensschritt 25 entbindert und gesintert. Dadurch wird das piezoelektrische Bauteil 1 gebildet. Bei dieser Ausgestaltung ist das elektrische Kontaktelement 13 mittels des elektrisch leitenden Hilfsstoffs 16 mit der innen liegenden Elektrodenschicht 9 elektrisch verbunden. Ferner ist das elektrische Kontaktelement 13 mittels des Hilfsstoffs 16 in der Bohrung 10 befestigt.

Bei einer weiteren möglichen Ausgestaltung folgt auf den Verfahrensschritt 21 der Verfahrensschritt 26. Im Verfahrensschritt 26 wird der mit der Bohrung 10 versehene Grünling 6 entbindert und gesintert. Dadurch wird ein gesinterter Grundkörper 6 mit einer Bohrung 10 ausgestaltet. Anschließend wird in die Bohrung 10 des gesinterten Grundkörpers 6 das elektrische Kontaktelement 13 mit dem Hilfsstoff 16 eingefügt. Der Hilfsstoff 16 kann hierbei aus einer Paste, insbesondere einer Metallisierungspaste, gebildet werden. Somit ist das elektrische Kontaktelement 13 in diesem Fall mittels des Hilfsstoff 16 in der Bohrung 10 mechanisch befestigt. Hierbei ist über den elektrisch leitenden Hilfsstoff 16 außerdem eine elektrische Verbindung des elektrischen Kontaktelements 13 mit der innen liegenden Elektrodenschicht 9 gewährleistet.

Bei einer weiteren möglichen Ausgestaltung folgt auf den Verfahrensschritt 20 der Verfahrensschritt 28. Im Verfahrensschritt 28 wird der massive Grünling 6 ohne eine Bohrung 10 hergestellt. Im Verfahrensschritt 29, der auf den Verfahrensschritt 28 folgt, wird der massive Grünling 6 entbindert und gesintert. Außerdem wird erst nach dem Entbindern und Sintern im Verfahrensschritt 29 die Bohrung 10 durch Anbohren des gesinterten Grundkörpers 6 ausgestaltet.

Im Verfahrensschritt 30, der auf den Verfahrensschritt 29 folgt, wird das elektrische Kontaktelement 13 über einen Hilfsstoff 16 in der Bohrung 10 befestigt. Über den elektrisch leitenden Hilfsstoff 16 ist hierbei auch eine elektrische Verbindung des elektrischen Kontaktelements 13 mit der innen liegenden Elektrodenschicht 9 gewährleistet. Der Hilfsstoff 16 kann hierbei aus einer Paste, insbesondere einer Metallisierungspaste, gebildet sein.

Somit kann das Kontaktelement 13 unter Zuhilfenahme elektrisch leitfähiger Pasten, insbesondere Metallisierungspasten, im piezoelektrischen Grundkörper 6 fixiert werden. Hierbei kann die Bohrung 10 entweder im Grünling 6 oder im gesinterten Grundkörper (Sinterling) 6 angebracht werden. Ferner kann die Metallisierungspaste entweder vor oder nach dem Sintern appliziert werden.

Somit kann zur elektrischen Außenkontaktierung der innen liegenden Elektrodenschicht 9 ein einzelnes elektrisches Kontaktelement 13 oder ein Verbund aus dem elektrischen Kontaktelement 13 und dem Hilfsstoff 16 dienen. Hierdurch kann eine mit dem Grundkörper 6 fest verbundene, einfache und robuste elektrische Kontaktierung gebildet werden.

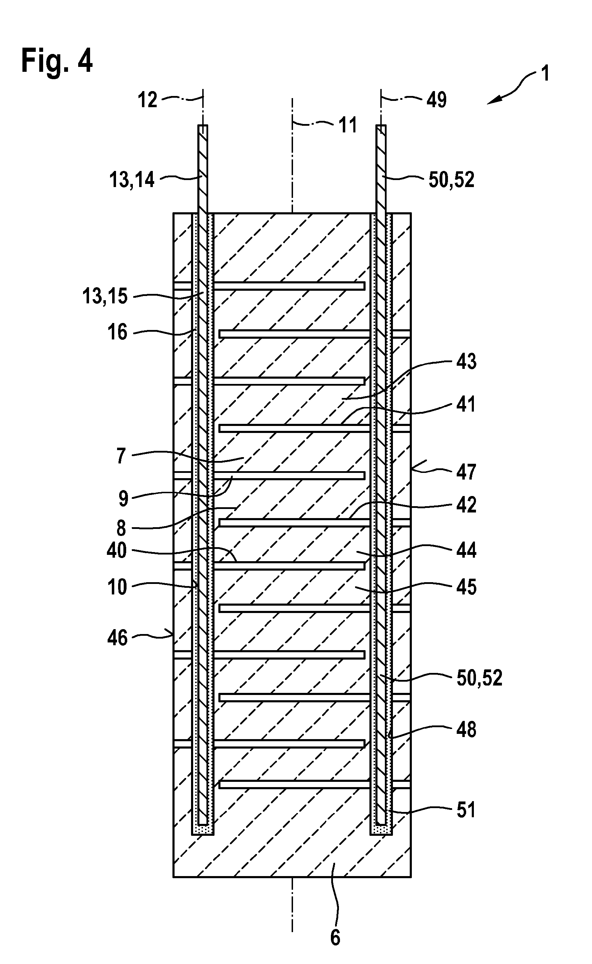

Fig. 4 zeigt ein piezoelektrisches Bauteil 1 entsprechend einem dritten Ausführungsbeispiel in einer schematischen Schnittdarstellung. In diesem Ausführungsbeispiel ist eine Achse 12 der Bohrung 10 parallel zu der Achse 11 des piezoelektrischen Bauteils 1 orientiert. Die Bohrung 10 erstreckt sich dadurch senkrecht zu der innen liegenden Elektrodenschicht 9.

Außerdem weist der Grundkörper 6 in diesem Ausführungsbeispiel eine Vielzahl von innen liegenden Elektrodenschichten 9, 40, 41, 42 auf, von denen in der Fig. 4 zur Vereinfachung der Darstellung nur die innen liegenden Elektrodenschichten 9, 40, 41, 42 gekennzeichnet sind. Außerdem weist der Grundkörper 6 eine Vielzahl von keramischen Schichten 7, 8, 43, 44, 45 auf, von denen in der Fig. 4 zur Vereinfachung der Darstellung nur die keramischen Schichten 7, 8, 43, 44, 45 gekennzeichnet sind.

Die innen liegenden Elektrodenschichten 9, 40, 41, 42 sind jeweils zwischen benachbarten keramischen Schichten 7, 8, 43, 44, 45 ausgestaltet. Hierbei erstrecken sich die innen liegenden Elektrodenschichten 7, 8, 40, 41, 42 nur teilweise über einen Querschnitt des Grundkörpers 6. Die innen liegenden Elektrodenschichten 9, 40 erstrecken sich bis zu einer Seite 46 des Grundkörpers 4 und sind von einer Seite 47 beabstandet. Andererseits erstrecken sich die innen liegenden Elektrodenschichten 41, 42 bis zu der Seite 47, wobei die innen liegenden Elektrodenschichten 41, 42 aber von der Seite 46 beabstandet sind.

In diesem Ausführungsbeispiel ist ferner eine weitere Bohrung 48 in dem Grundkörper 6 ausgebildet. Eine Achse 49 der Bohrung 48 ist hierbei ebenfalls parallel zu der Achse 11 des Grundkörpers 6 orientiert.

Das elektrische Kontaktelement 13 ist über den Hilfsstoff 16 elektrisch mit den innen liegenden Elektrodenschichten 9, 40 verbunden.

Ein weiteres elektrisches Kontaktelement 50 ist in der Bohrung 48 angeordnet. Hierbei ist ebenfalls ein Hilfsstoff 51 vorgesehen, mit dem das elektrische Kontaktelement 50 an seinem Verbindungsabschnitt 52 mechanisch in der Bohrung 10 befestigt ist. Ferner ist das weitere elektrische Kontaktelement 50 über den elektrisch leitenden Hilfsstoff 51 mit den innen liegenden Elektrodenschichten 41, 42 elektrisch verbunden. Ein freiliegender Abschnitt 52 des elektrischen Kontaktelements befindet sich außerhalb der Bohrung 48.

Auf diese Weise kann somit eine abwechselnde elektrische Kontaktierung mehrerer innen liegender Elektrodenschichten 9, 40, 41, 42 erzielt werden.

Die Erfindung ist nicht auf die beschriebenen Ausführungsbeispiele beschränkt.

## Patentansprüche

1. Piezoelektrisches Bauteil (1), insbesondere piezoelektrischer Sensor oder piezoelektrischer Aktor, mit einem Grundkörper (6), der eine erste keramische Schicht (7), eine zweite keramische Schicht (8) und eine innen liegende Elektrodenschicht (9) aufweist, wobei die innen liegende Elektrodenschicht (9) zumindest teilweise zwischen der ersten keramischen Schicht (7) und der zweiten keramischen Schicht (8) vorgesehen ist, wobei der Grundkörper (6) eine Bohrung (10) aufweist, die zumindest teilweise im Bereich der innen liegenden Elektrodenschicht (9) vorgesehen ist, und wobei in die Bohrung (10) des Grundkörpers (6) zumindest teilweise ein elektrisches Kontaktelement (13) eingefügt ist, das in der Bohrung zumindest mittelbar mit der innen liegenden Elektrodenschicht (9) elektrisch verbunden ist.

2. Piezoelektrisches Bauteil nach Anspruch 1,
**dadurch gekennzeichnet,**
**dass** das elektrische Kontaktelement (13) durch Klemmen in der Bohrung (10) des Grundkörpers (6) befestigt ist.

3. Piezoelektrisches Bauteil nach Anspruch 1,
**dadurch gekennzeichnet,**
**dass** das elektrische Kontaktelement (13) mittels eines Hilfsstoffes (16) in der Bohrung (10) des Grundkörpers (6) befestigt ist.

4. Piezoelektrisches Bauteil nach Anspruch 3,
**dadurch gekennzeichnet,**
**dass** der Hilfsstoff (16) als elektrisch leitender Hilfsstoff ausgebildet ist und dass das elektrische Kontaktelement (13) mittels des elektrisch leitenden Hilfsstoffes (16) mit der innen liegenden Elektrodenschicht (9) elektrisch verbunden ist.

5. Piezoelektrisches Bauteil nach einem der Ansprüche 1 bis 4,
**dadurch gekennzeichnet,**
**dass** eine Achse (12) der Bohrung (10) zumindest näherungsweise parallel zu der innen liegenden Elektrodenschicht (9) orientiert ist.

6. Piezoelektrisches Bauteil nach einem der Ansprüche 1 bis 4,
**dadurch gekennzeichnet,**
**dass** zumindest eine weitere innen liegende Elektrodenschicht (40) vorgesehen ist, dass die Bohrung (10) zumindest teilweise im Bereich der weiteren innen liegenden Elektrodenschicht (40) vorgesehen ist und dass eine Achse (12) der Bohrung (10) zumindest näherungsweise senkrecht zu der innen liegenden Elektrodenschicht (9) und der weiteren innen liegenden Elektrodenschicht (40) orientiert ist.

7. Verfahren zur Herstellung eines piezoelektrischen Bauteils (1), insbesondere eines piezoelektrischen Sensors oder eines piezoelektrischen Aktors, wobei ein Grünling (6) für einen Grundkörper (6) des Bauteils (1) hergestellt wird, der eine erste keramische Schicht (7), eine zweite keramische Schicht (8) und eine innen liegende Elektrodenschicht (9) aufweist, die zumindest teilweise zwischen der ersten keramischen Schicht (7) und der zweiten keramischen Schicht (8) vorgesehen ist, wobei in dem Grundkörper (6) eine Bohrung (10) ausgestaltet wird, die zumindest teilweise im Bereich der innen liegenden Elektrodenschicht (9) vorgesehen ist, und wobei in die Bohrung (10) des Grundkörpers (6) zumindest teilweise ein elektrisches Kontaktelement (13) eingefügt wird, das in der Bohrung (10) zumindest mittelbar mit der innen liegenden Elektrodenschicht (9) verbunden wird.

8. Verfahren nach Anspruch 7,
**dadurch gekennzeichnet,**
**dass** die Bohrung (10) in den Grünling (6) eingebracht wird.

9. Verfahren nach Anspruch 8,
**dadurch gekennzeichnet,**
**dass** das elektrische Kontaktelement (13) zumindest teilweise direkt in die Bohrung (10) des Grünlings (6) eingebracht wird und dass der Grünling (6) mit dem in die Bohrung (10) eingebrachten elektrischen Kontaktelement (13) gesintert wird, wobei das elektrische Kontaktelement (13) aufgrund einer Sinterschwindung des Grünlings (6) direkt in der Bohrung (10) des Grundkörpers (6) befestigt wird.

10. Verfahren nach Anspruch 8,
**dadurch gekennzeichnet,**
**dass** das elektrische Kontaktelement (13) mittels einer Paste (16) zumindest teilweise in die Bohrung (10) des Grünlings (6) eingebracht wird und dass der Grünling (6) mit dem mittels der Paste (16) in die Bohrung (10) eingebrachtem elektrischen Kontaktelement (13) gesintert wird, wobei das elektrische Kontaktelement (13) durch den aus der Paste (16) gebildeten Hilfsstoff (16) in der Bohrung (10) des Grundkörpers (6) befestigt wird.

11. Verfahren nach Anspruch 8,
**dadurch gekennzeichnet,**
**dass** der Grünling (6), in den die Bohrung (10) eingebracht ist, gesintert wird und dass das elektrische Kontaktelement (13) nach dem Sintern mittels eines Hilfsstoffes (16) zumindest teilweise in die Bohrung (10) des Grundkörpers (6) eingefügt wird, wobei das elektrische Kontaktelement (13) in der Bohrung (10) durch den Hilfsstoff (16) mit dem Grundkörper (6) verbunden wird.

12. Verfahren nach Anspruch 7,
**dadurch gekennzeichnet,**
**dass** der Grünling (6) für den Grundkörper (6) gesintert wird und dass die Bohrung (10) nach dem Sintern in dem Grundkörper (6) ausgestaltet wird.
